Europäisches Patentamt

European Patent Office

Office européen des brevets

(11) Veröffentlichungsnummer: **0 499 770 A2**

# EUROPÄISCHE PATENTANMELDUNG

(21) Anmeldenummer: **92100072.5**

(51) Int. Cl.⁵: **C23C 14/34**

(22) Anmeldetag: **03.01.92**

(30) Priorität: **21.02.91 DE 9102052 U**

(43) Veröffentlichungstag der Anmeldung:
**26.08.92 Patentblatt 92/35**

(84) Benannte Vertragsstaaten:
**BE DE DK ES FR GB GR IT LU NL**

(71) Anmelder: **HAUZER HOLDING B.V.**
**Groethofstraat 27**
**NL-5900 AE Venlo(NL)**

(72) Erfinder: **Münz, Wolf-Dieter, Dr.**
**Gerard de Vlamingstraat 9**
**NL-5913 RV Velden(NL)**

(74) Vertreter: **Dipl.-Phys.Dr. Manitz**
**Dipl.-Ing.Dipl.-Wirtsch.-Ing. Finsterwald**
**Dipl.-Phys. Rotermund Dipl.-Chem.Dr. Heyn**
**B.Sc.(Phys.) Morgan**
**Robert-Koch-Strasse 1**
**W-8000 München 22(DE)**

(54) **Indirekt gekühltes Target mit Schnellwechselsystem.**

(57) Es wird ein zur Verwendung in einer Vorrichtung zum Beschichten von Substraten unter Vakuum bestimmter Verdampfer beschrieben, der aus einer Halterung und einer an der Halterung lösbar befestigten Targetplatte besteht, die rückseitig durch ein die Halterung durchströmendes Kühlmedium beaufschlagt ist. Zur Ermöglichung eines schnellen Wechsels der Targetplatte unter gleichzeitiger Optimierung der Kühlung ist die Targetplatte an der Halterung über eine Klemmverbindung mit ineinandergreifenden Klemmflächen fixiert.

Fig. 1

Die Erfindung betrifft einen Verdampfer, insbesondere zur Verwendung in einer Vorrichtung zum Beschichten von Substraten unter Vakuum.

Im allgemeinen wird unter einem Vorgang des Aufdampfens oder Beschichtens die Verdampfung wenigstens eines Materials, das in Form eines Targets vorliegt, verstanden, und zwar zum Zwecke der Kondensierung dieses Materials oder dieser Materialien auf unterschiedlichen Substraten bzw. Produkten. Dieser Vorgang des Verdampfens wird unter Vakuum durchgeführt, um eine kontrollierbare und reproduzierbare Atmosphäre zu gewährleisten. Durch Zuführung verschiedener Gase während der Targetverdampfung entsteht eine Reaktion zwischen dem verdampften Targetmaterial und den Reaktivgasen. Auf diese Weise können verschiedenste Schichten zur Verbesserung von Substratoberflächen hergestellt werden.

Ein wesentlicher Bestandteil von Vorrichtungen zur Durchführung einer derartigen Substratbeschichtung ist der sog. Verdampfer. Dieser Verdampfer muß so hergestellt werden, daß während des Verdampfens des Targetmaterials Wärme abgeführt werden kann. Es ist bekannt, die Targetplatte dazu auf einer speziellen Halterung zu montieren und die Rückseite der Targetplatte direkt mittels eines z.B. aus Wasser bestehenden Kühlmittels zu kühlen. Die Targetplatte ist dabei auf der Targethalterung durch Schraubverbindungen fixiert, wobei diese Fixierung bzw. Verbindung der Targetplatte mit der Targethalterung so erfolgen muß, daß ein Eindringen des Kühlmittels in die Vakuumanlage mit Sicherheit vermieden wird.

Die bei bekannten Verdampfern verwendeten Schraubverbindungen zur Fixierung der Targetplatte sind stets mit dem Nachteil behaftet, daß der Gewinderaum schwer zu evakuieren ist. Da Schraubverbindungen unter Vakuum außerdem nicht geschmiert werden dürfen, ist stets die Gefahr gegeben, daß die Schraubverbindungen nicht mehr gelöst werden können. Schließlich ist bei diesen Schraubverbindungen noch nachteilig, daß der zum Wechseln einer Targetplatte erforderliche Zeitaufwand relativ groß ist.

Ein weiterer Nachteil bekannter Verdampfer besteht in der direkten Kühlung der Rückseite der Targetplatte, da dabei stets die Gefahr besteht, daß der Vakuumverschluß leckt. Dies tritt insbesondere auf bei bestimmten Targetmaterialien, und zwar bei häufigem Wechsel der Targetplatten sowie bei Abnutzung des Dichtmaterials. Selbst bei sehr geringer Menge von in die Vakuumanlage eintretender Kühlflüssigkeit ist dies von verheerender Auswirkung für den Vakuumprozeß. Schließlich kann es auch noch geschehen, daß beim Wechseln der Targetplatte Reste des Kühlmittels die Anlage verunreinigen, und es kann damit zusammenfassend zu den herkömmlichen Verdampfern festgestellt werden, daß deren direkte Kühlung und deren Schraubbefestigung an einer Targethalterung gravierende Probleme beim Targetplattenwechsel sowie einen unerwünscht hohen Zeitaufwand verursachen.

Aufgabe der Erfindung ist es, die Nachteile der bekannten Verdampfer zu beseitigen und einen Verdampfer der eingangs angegebenen Art zu schaffen, der nicht nur einen schnellen und problemfreien Wechsel der jeweiligen Targetplatte ermöglicht, sondern gleichzeitig eine optimale Kühlung unter Vermeidung der Gefahr der Verunreinigung des Vakuumraumes gewährleistet.

Gelöst wird diese Aufgabe nach der Erfindung im wesentlichen dadurch, daß die Targetplatte an der Halterung über eine Klemmverbindung mit ineinandergreifenden Klemmflächen fixiert ist. Diese Klemmverbindung ist vorzugsweise als Bajonett-Klemmverschluß ausgebildet.

Neben dem Vorteil der Verringerung bzw. praktischen Beseitigung von Schraubverbindungen wird durch die erfindungsgemäßen Maßnahmen auch eine Minimierung der zur Targetauswechslung benötigten Zeit erreicht. Vorzugsweise befindet sich zwischen dem Kühlmittel und dem Target eine Kupferfolie, die mit der Targethalterung vakuumdicht verbunden ist und die einen einwandfreien Vakuumverschluß garantiert. Während des Auswechselns der Targetplatte ist es somit nicht möglich, daß eine Verunreinigung der Anlage durch das Kühlmittel erfolgt.

Ein weiterer wesentlicher Vorteil des erfindungsgemäßen Verdampfers besteht darin, daß die Dicke der Kupferfolie so gewählt wird, daß bei Kühlung des Verdampfers der Druck des Kühlmittels die Kupferfolie gegen die Targetplatte drückt. Dies hat zum einen den Vorteil, daß ein guter Wärmeaustausch zwischen der Targetplatte und dem Kühlmittel stattfindet, und daß zum anderen die Targetplatte automatisch gegen den Klemmverschluß, insbesondere Bajonettverschluß fixiert wird, und zwar durch den Kühlflüssigkeitsdruck.

In der Praxis von besonderem Vorteil ist ferner die Ausgestaltung des Verdampfers in der Weise, daß seine Rückseite bzw. atmosphärische Seite gut zugänglich ist und eine günstige Montage der erforderlichen Magnetkonfiguration ermöglicht. Diese Magnetkonfiguration kann nämlich möglichst nahe an der Targetplatte montiert werden, was auch dadurch begünstigt wird, daß bei der erfindungsgemäßen Ausgestaltung des Verdampfers die Dicke der Targetrahmen hinter der Targetplatte minimal ist.

Obwohl die Verwendung eines Bajonettverschlußes als Klemmverbindung zwischen Targethalterung und Targetplatte bevorzugt ist, lassen sich auch unter Realisierung der beschriebenen Vorteile der Erfindung Klemmverbindungen anderer Art, z.B. Schiebe-Führungsverbindungen oder Schwalbenschwanzverbindungen verwenden.

Die Erfindung wird nachfolgend anhand eines Ausführungsbeispiels unter Bezugnahme auf die Zeichnung erläutert; in der Zeichnung zeigt:

Fig. 1 einen Axialschnitt eines Verdampfers nach der Erfindung, und

Fig. 2 eine Draufsicht der Bajonett-Halterung nach Fig. 1.

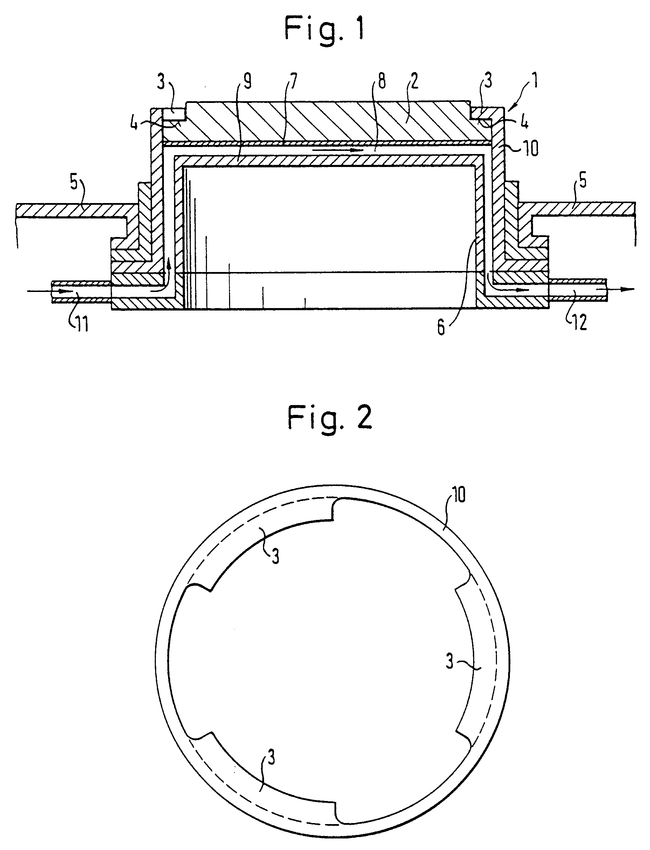

Fig. 1 zeigt eine mit einem nur teilweise dargestellten Vakuumgefäß 5 dicht verbundene, mit dem allgemeinen Bezugszeichen 1 gekennzeichnete Targethalterung.

Diese Targethalterung 1 besteht aus einem Außenzylinder 10 und einem Innenzylinder 6, der koaxial und mit Abstand bezüglich des Außenzylinders 10 angeordnet ist.

Der Außenzylinder 10 weist an seinem freien Ende Haltemittel für eine auswechselbare Targetplatte 2 auf. Zur Targetplatte 2 hin ist der Innenzylinder 6 durch eine Abschlußwand 9 und der Außenzylinder 10 durch eine metallische Folie 7 abgeschlossen. Zwischen der Abschlußwand 9 und der metallischen Folie 7 ist ein Strömungsraum 8 für ein Kühlmittel ausgebildet.

Die Zuführung des Kühlmittels erfolgt über eine bezüglich Innenzylinder 6 und Außenzylinder 10 radial verlaufende Kühlmittel-Zuführleitung 11, und die Ableitung über eine vorzugsweise dazu diametral liegende Kühlmittel-Abführleitung 12.

Die metallische Folie 7, die den Kühlmittelraum von dem Vakuumraum innerhalb des Gefäßes 5 trennt, ist mit dem Außenzylinder 10 vakuumdicht verbunden, und zwar vorzugsweise durch Hochtemperaturlöten, wodurch ein einwandfreier Vakuumverschluß garantiert ist.

Die metallische Folie 7, die vorzugsweise aus einer Kupferfolie besteht, hat nicht nur die Aufgabe, jegliches Eindringen von Kühlmittel in das Vakuumgefäß mit Sicherheit auszuschließen, sondern sie gewährleistet aufgrund ihrer hohen Wärmeleitfähigkeit und ihrer vollflächigen Anlage am Target 2 auch einen besonders guten Wärmeübergang zwischen Target 2 und Kühlflüssigkeit, und sie hat überdies die wesentliche Aufgabe, die Klemmfixierung der Targetplatte 2 zu unterstützen.

Die Befestigung der Targetplatte 2 an der Halterung 1 erfolgt über eine Klemmverbindung mittels ineinandergreifender Klemmflächen 3, 4, wobei diese Klemmflächen durch eine Schiebe- und/oder Relativverdrehung zwischen Halterung 1 und Targetplatte 2 in Eingriff gebracht werden können. Bei der dargestellten Ausführungsform erfolgt die Klemmverbindung durch eine Relativverdrehung, da die Klemmverbindung als Bajonettverschluß ausgebildet ist. Wenn die Klemmflächen 3, 4 ihre relative Sollposition einnehmen und damit die Targetplatte 2 bezüglich der Halterung 1 fixiert ist, wird nach dem Aufbau des Kühlflüssigkeitsdrucks über die metallische Folie 7 ein Klemm- bzw. Haltedruck auf die Klemmflächen 3, 4 ausgeübt und damit die Befestigung der Targetplatte 2 in der Halterung 1 wirksam unterstützt.

Die Draufsicht nach Fig. 2 zeigt drei gleichmäßig über den Umfang verteilt angeordnete Klemmflächen 3, die bezüglich des Außenzylinders 10 radial nach innen vorspringen und entsprechend ausgebildete Klemmflächen an der Targetplatte 2 übergreifen, wenn die Targetplatte 2 eingesetzt und durch eine Drehbewegung in die Fixierlage überführt ist.

Die wesentlichen Vorteile der erfindungsgemäßen Verdampferkonstruktion im Vergleich zu bekannten Anordnungen bestehen darin, daß die vakuumtechnischen Verbindungen entscheidend verbessert sind, daß Verunreinigungen der Anlage während des Auswechselns der Targetplatte ausgeschlossen werden können, daß die zum Auswechseln der Targetplatte benötigte Zeit minimiert wurde, daß neben der einwandfreien Befestigung der Targetplatte die Sicherheit des Verdampfers bezüglich Leckgefahr erhöht ist und daß die erforderliche Magnetkonfiguration in einer optimal wirksamen und zugänglichen Position angeordnet werden kann.

Bezugszeichenliste

| 1 | Halterung |
|---|---|
| 2 | Targetplatte |
| 3 | Klemmfläche |
| 4 | Klemmfläche |
| 5 | Vakuumgefäß |
| 6 | Innenzylinder |
| 7 | Metallische Folie |
| 8 | Strömungsraum |
| 9 | Abschlußwand |
| 10 | Außenzylinder |
| 11 | Kühlmittel-Zuführleitung |
| 12 | Kühlmittel-Abführleitung |

**Patentansprüche**

1. Verdampfer, insbesondere zur Verwendung in einer Vorrichtung zum Beschichten von Substraten unter Vakuum, bestehend aus einer Halterung (1) sowie einer an der Halterung (1) lösbar befestigten Targetplatte (2), die rückseitig durch ein die Halterung (1) durchströmendes Kühlmedium beaufschlagt ist,
   dadurch **gekennzeichnet**,
   daß die Targetplatte (2) an der Halterung (1) über eine Klemmverbindung mit ineinandergreifenden Klemmflächen (3, 4) fixiert ist.

2. Verdampfer nach Anspruch 1,

dadurch **gekennzeichnet**,
daß die Klemmverbindung als Bajonett-Klemmverschluß ausgebildet ist.

3. Verdampfer nach Anspruch 1 oder 2,
dadurch **gekennzeichnet**,
daß die Halterung (1) aus einem sich in das Vakuumgefäß (5) erstreckenden Außenzylinder (10) und einem dazu koaxialen Innenzylinder (6) besteht, daß der Außenzylinder (10) an seinem freien Ende Klemmflächen (3) zur Befestigung der Targetplatte (2) aufweist und daß zwischen dem Außenzylinder (10) und dem Innenzylinder (6) ein Kühlmittel-Strömungsraum (8) ausgebildet ist.

4. Verdampfer nach Anspruch 3,
dadurch **gekennzeichnet**,
daß der Abschlußwand (9) des Innenzylinders (6) gegenüberliegend eine metallische Folie (7) angeordnet ist, die über ihren gesamten Umfang am Außenzylinder vakuumdicht befestigt ist und dessen Abschlußwand bildet.

5. Verdampfer nach Anspruch 4,
dadurch **gekennzeichnet**,
daß die metallische Folie (7) aus Kupfer besteht und durch eine Hochtemperaturlötung vakuumdicht mit dem Außenzylinder (10) verbunden ist.

6. Verdampfer nach einem der vorhergehenden Ansprüche,
dadurch **gekennzeichnet**,
daß die die Abschlußwand des Außenzylinders (10) bildende metallische Folie (7) die Klemmverbindung zwischen Halterung (1) und Targetplatte (2) in Abhängigkeit vom Druck des durch den Strömungsraum (8) geleiteten Kühlmediums blockierend beaufschlägt.

7. Verdampfer nach einem der vorhergehenden Ansprüche,
dadurch **gekennzeichnet**,
daß der Innenzylinder (6) einen Aufnahmeraum für eine Magnetkonfiguration bildet.

# Fig. 1

# Fig. 2